# EUROPEAN PATENT APPLICATION

(11) **EP 4 439 658 A1**
(43) Date of publication of application: **02.10.2024**
(21) Application number: 23164967.4
(22) Date of filing: 29.03.2023
(51) Int. Cl.: H01L 23/495, H01L 23/00, B33Y 10/00, H01L 23/367

(54) **A METHOD FOR MANUFACTURING A SEMICONDUCTOR PACKAGE ASSEMBLY AS WELL AS A SEMICONDUCTOR PACKAGE ASSEMBLY OBTAINED WITH THIS METHOD**

(71) Applicant: Nexperia B.V., 6534 AB Nijmegen (NL)
(72) Inventor: Lam, Hiu Hay Nichole, Hong Kong (HK); Yeung, Shun Tik, Hong Kong (HK)
(74) Representative: Pjanovic, Ilija

(57) **Abstract**

A method for manufacturing a leaded/leadless power/MCD package or power module is proposed with less complex and less time-consuming process steps, and wherein the connecting elements being implemented are of a simple design with reduced R_{DS(on)} characteristic. It comprises the sub-steps i1) providing a lead frame, and providing in step i2) at least one semiconductor die structure on the lead frame. The step i-3) of forming one or more connection elements between the at least one semiconductor die structures and the at least two terminals of the lead frame comprises at least one forming sequence of the sub steps of i3-1) of providing a layer of a metal powder such that the metal powder is in contact with the at least one semiconductor die structure and one of the at least two terminals of the lead frame; and sub-step i3-2) of selectively melting with laser light radiation, the layer of the metal powder to form a metal layer.

In a final step ii) the at least one semiconductor die structure, the one or more connection elements and the plurality of terminals are encapsulated with a molding resin leaving at least a portion of at least two terminals exposed, thereby forming at least one encapsulated semiconductor package assembly.

## Description

### TECHNICAL FIELD

The present disclosure relates to techniques for manufacturing a semiconductor package assembly, wherein a semiconductor die structure is mounted to a lead frame having terminals and encapsulated with a molding resin, as well as a semiconductor package assembly obtained with these techniques.

### BACKGROUND OF THE DISCLOSURE

In conventional leaded/leadless power/MCD packages or power modules various connection elements are implemented for electrically and mechanically interconnecting semiconductor die structures with the various terminals of the lead frame. Examples of such electrical and mechanical connection elements are standard wire bonds, ribbon bonds or clip bonds, which requires different process steps to be applied during the power module or semiconductor package assembly manufacturing process.

Although these known connection elements are immobilized by means of an encapsulant, these fragile bonds are still prone to connectivity failures over time. In addition, these known bonding techniques are costly, complex, cumbersome and thus time consuming, as they require pre-designed and pre-manufactured connecting elements, and time-consuming handling steps for mounting these connecting elements in the manufacturing process. Also, these conventional leaded/leadless power/MCD packages or power modules still exhibit a high R_{DS(on)} (drain-source on resistance) limiting their performance.

Accordingly, an object of the present disclosure is to provide a manufacturing technique obviating the above identified problems, resulting in a leaded/leadless power/MCD package or power module manufactured with less complex and less time-consuming process steps, and wherein the connecting elements being implemented are of a straightforward design with reduced R_{DS(on)} characteristic.

### SUMMARY OF THE DISCLOSURE

According to a first example of the disclosure, a method for manufacturing a leaded/leadless power/MCD package or power module is proposed with less complex and less time-consuming process steps, and wherein the connecting elements being implemented are of a simple design with reduced R_{DS(on)} characteristic.

The method comprises the steps of i) forming at least one semiconductor package by means of the sub-steps: i1) providing a lead frame made from a metal material having a first frame side and a second frame side opposite to the first frame side as well as having at least two terminals. Subsequently in a step i2) at least one semiconductor die structure is provided having a first die side and a second die side opposite to the first side, which semiconductor die structure is mounted with its second die side on the first frame side of the lead frame.

In a subsequent step i-3), one or more connection elements are provided between the at least one semiconductor die structures and the at least two terminals of the lead frame and in a final step ii) the at least one semiconductor die structure, the one or more connection elements and the plurality of terminals are encapsulated with a molding resin leaving at least a portion of at least two terminals exposed, thereby forming at least one encapsulated semiconductor package assembly.

In particular the step i3) of providing the several connection elements comprises at least one forming sequence of the sub steps of i3-1) providing a layer of a metal powder such that the metal powder is in contact with the at least one semiconductor die structure and one of the at least two terminals of the lead frame; and sub-step i3-2) of selectively melting, with laser light radiation, the layer of the metal powder to form a metal layer.

With the sequence of the two sub-steps i3-1) and i3-2), wherein the connecting elements are formed layer-by-layer through a metal powder layer deposition and solidifying, the known Cu clip bonds or Cu wire bonds are replaced and any process time for panel level packaging is significantly reduced. Furthermore, the manufacturing technique of connecting elements is more flexible compared to the known bond wire / bond clip forming techniques, which requires pre-designed and pre-manufactured components.

In addition, the layer-by-layer deposition technique implemented allows a better material handling, reducing material stresses in the connecting elements thus reducing connectivity failures over time and extending the life span of the resulting leaded/leadless power/MCD package or power module. Also, such manufacturing technique as outlined in sub-steps i3-1) and i3-2) result in a reduced (lower) R_{DS(on)} characteristic compared to the known conventional interconnect methods. This because the whole interconnecting interface between the various components (semiconductor die structure and lead frame) will be of the same metal layer material. Solder and/or adhesive promoters between the semiconductor die structure and resulting connecting elements and between the connecting elements and the lead frame can be omitted as the metal powder connection can be fused in between the material.

In a particular example, the forming sequence of the steps i3-1) and i3-2) is performed multiple times alternately, thereby forming a three-dimensional stack of subsequent melted metal layers.

Contrary to the known pre-designed and pre-manufactured connecting elements, the method according to the disclosure allows for a more flexible layer-by-layer forming of the connecting elements as a local thickness and/or a local density of each metal layer formed during a forming sequence of the steps i3-1) and i3-2) can be effectively controlled by adjusting one or more manufacturing parameters chosen from the group of:
- a metal powder distribution;
- a supply velocity of metal powder to be deposited;
- a metal powder depositing angle relative to a plane formed by the lead frame;
- a laser light power;
- a laser light frequency;
- a laser light wavelength;
- an ambient process temperature;
- a metal powder depositing duration time of step i3-1);
- a metal powder melting duration time of step i3-2).

Effectively, the method according to the disclosure allows for each metal layer being formed in step i3-2) in having a thickness of 30-40 µm, preferably 35 µm.

The above design flexibility of the connecting elements in a layer-by-layer fashion allows in an example of the method according to the disclosure to have a surface dimension of a metal layer being larger or smaller than the surface dimension of the metal layer formed during the previous forming sequence. Herewith complex three-dimensionally shaped connecting elements can be formed depending on their functionality.

In a further example of the method, a step iii) is implemented, after a final forming sequence of steps i3-1) and i3-2) but before step ii), which step subjects the exposed portion of the at least two terminals to a surface roughening treatment, for example using a chemical agent.

Accordingly, in a further step iv), after step ii) or step iii), the exposed portion of the at least two terminals is plated with a metal plating material. Preferably, said metal plating material is Tin.

Finally, the method according to the disclosure comprises the step v), performed after step iv), of singulating the encapsulated semiconductor package from the lead frame, thereby forming a single semiconductor package assembly.

Likewise the disclosure pertains to a semiconductor package assembly composed of at least one semiconductor die structure electrically and mechanically attached by means of one or more connection elements with at least two terminals and encapsulated by a molding resin such that a portion of the at least two terminals are exposed, wherein the one or more connection elements between the semiconductor die structure and the at least two terminals are formed according to the method steps of the present disclosure.

In particular examples, the semiconductor package assembly is a leadless semiconductor package assembly or a leaded semiconductor package assembly.

### BRIEF DESCRIPTION OF THE DRAWINGS

The disclosure will now be discussed with reference to the drawings, which show in:
Figure 1 an example of the process steps of the method according to the disclosure;
Figure 2a-2b a top view and a sectional side view of an example of a leaded semiconductor package assembly according to the disclosure;
Figure 3a-3b a top view and a detailed view of an example of a power module according to the disclosure;
Figure 4a-4b a top view and a sectional side view of an example of a leadless semiconductor package assembly according to the disclosure.

### DETAILED DESCRIPTION OF THE DISCLOSURE

For a proper understanding of the disclosure, in the detailed description below corresponding elements or parts of the disclosure will be denoted with identical reference numerals in the drawings.

As outlined above, apart from the fragile known electrical and mechanical connection elements being immobilized by means of an encapsulant, they are still prone to connectivity failures over time. In addition, these known bonding techniques are costly, complex, cumbersome and thus time consuming, as they require pre-designed and pre-manufactured connecting elements, and time-consuming handling steps for mounting these connecting elements in the manufacturing process. Also, these conventional leaded/leadless power/MCD packages or power modules still exhibit a high R_{DS(on)} (drain-source on resistance) limiting their performance.

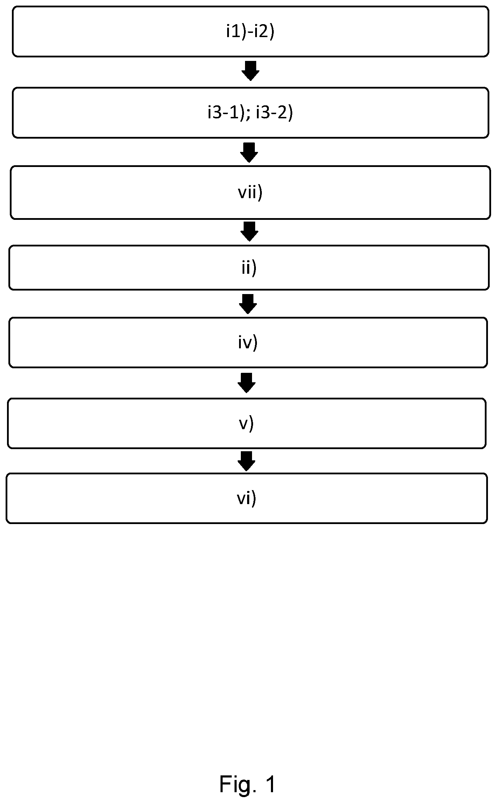

Figure 1 depicts a flow chart of the process steps of a manufacturing method according to the disclosure for manufacturing a leaded/leadless power/MCD package or power module with less complex and less time-consuming process steps, and wherein the connecting elements being implemented are of a simple design with reduced R_{DS(on)} characteristic.

The method comprises the steps of i) forming at least one semiconductor package by means of the sub-steps: i1) providing a lead frame made from a metal material having a first frame side and a second frame side opposite to the first frame side as well as having at least two terminals. Subsequently in a step i2) at least one semiconductor die structure is provided having a first die side and a second die side opposite to the first side, which semiconductor die structure is mounted with its second die side on the first frame side of the lead frame.

In a subsequent step i3), one or more connection elements are provided between the at least one semiconductor die structures and the at least two terminals of the lead frame and in a final step ii) the at least one semiconductor die structure, the one or more connection elements and the plurality of terminals are encapsulated with a molding resin leaving at least a portion of at least two terminals exposed, thereby forming at least one encapsulated semiconductor package assembly.

In particular the step i3) of providing the several electrical and mechanical connection elements comprises at least one forming sequence of the sub steps of i3-1) providing a layer of a metal powder such that the metal powder is in contact with the at least one semiconductor die structure and one of the at least two terminals of the lead frame; and sub-step i3-2) of selectively melting with laser light radiation, the layer of the metal powder to form a metal layer. The step of providing a layer of metal powder may constitute depositing the powder particles, whereas the step of selectively melting may also encompass solidifying or sintering the metal powder.

With the sequence of the two sub-steps i3-1) and i3-2), wherein the connecting elements are formed layer-by-layer through a metal powder layer deposition and solidifying, the known Cu clip bonds or Cu wire bonds are replaced and any process time for panel level packaging is significantly reduced. Furthermore, the manufacturing technique of connecting elements is more flexible compared to the known bond wire / bond clip forming techniques, which requires pre-designed and pre-manufactured components.

In addition, the layer-by-layer deposition technique implemented allows a better material handling, reducing material stresses in the connecting elements thus reducing connectivity failures over time and extending the life span of the resulting leaded/leadless power/MCD package or power module. Also, such manufacturing technique as outlined in sub-steps i3-1) and i3-2) result in a reduced (lower) R_{DS(on)} characteristic compared to the known conventional interconnect methods. This because the whole interconnecting interface between the various components (semiconductor die structure and lead frame) will be of the same metal layer material. Solder and/or adhesive promoters between the semiconductor die structure and resulting connecting elements and between the connecting elements and the lead frame can be omitted as the metal powder connection can be fused in between the material.

In a particular example, the forming sequence of the steps i3-1) and i3-2) is performed multiple times alternately, thereby forming a three-dimensional stack of subsequent melted metal layers.

Contrary to the known pre-designed and pre-manufactured connecting elements, the method according to the disclosure allows for a more flexible layer-by-layer forming of the connecting elements as a local thickness and/or a local density of each metal layer formed during a forming sequence of the steps i3-1) and i3-2) can be effectively controlled by adjusting one or more manufacturing parameters chosen from the group of:
- a metal powder distribution;
- a supply velocity of metal powder to be deposited;
- a metal powder depositing angle relative to a plane formed by the lead frame;
- a laser light power;
- a laser light frequency;
- a laser light wavelength;
- an ambient process temperature;
- a metal powder depositing duration time of step i3-1);
- a metal powder melting duration time of step i3-2).

Effectively, the method according to the disclosure allows for each metal layer being formed in step i3-2) in having a thickness of 30-40 µm, preferably 35 µm.

The above design flexibility of the connecting elements in a layer-by-layer fashion allows in an example of the method according to the disclosure to have a surface dimension of a metal layer being larger or smaller than the surface dimension of the metal layer formed during the previous forming sequence. Herewith complex three-dimensionally shaped connecting elements can be formed depending on their functionality.

In a further example of the method, a step iii) is implemented, after a final forming sequence of steps i3-1) and i3-2) but before step ii), which step subjects the exposed portion of the at least two terminals to a surface roughening treatment, for example using a chemical agent.

Accordingly, in a further step iv), after step ii) or step iii), the exposed portion of the at least two terminals is plated with a metal plating material. For example, electroplating can be used. Preferably, said metal plating material is different from the metal material of the terminals. In an example said metal plating material is Tin.

Finally, the method according to the disclosure comprises the step v), performed after step iv), of singulating the encapsulated semiconductor package from the lead frame, thereby forming a single semiconductor package assembly.

An post-processing step may encompass a visual inspection step vi). Optionally, a step vii) is performed, before the encapsulating step ii) of providing one or more bond wires (e.g. functioning as gate wires) between the semiconductor die structure 2 and one of the other frame terminals.

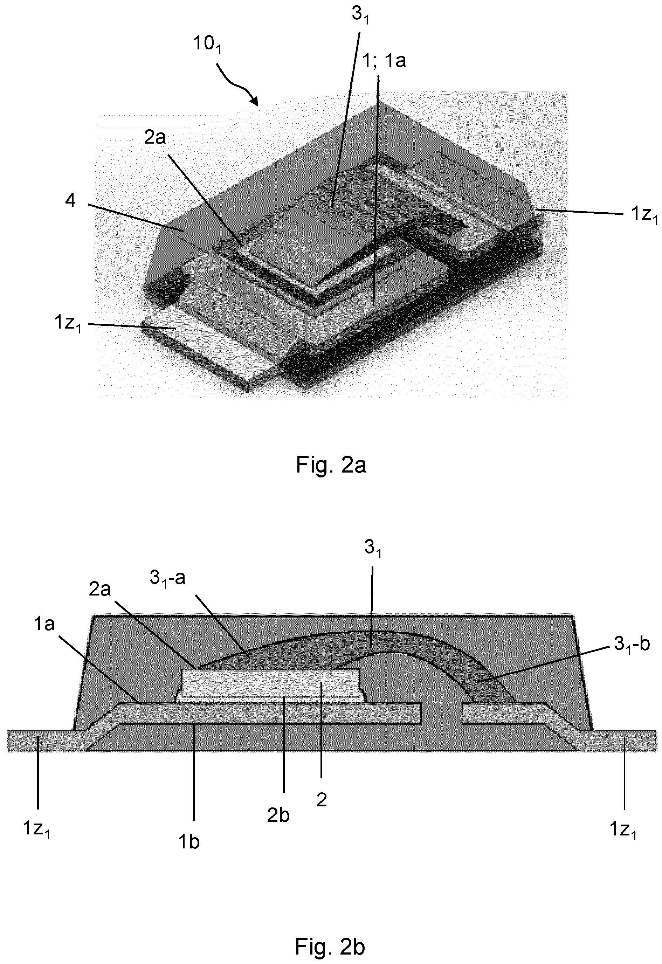

Figure 2a-2b show a top view and a sectional side view of an example of a singulated leaded semiconductor package assembly 10, according to the disclosure. The leaded semiconductor package assembly 10, is formed of three components. A first component is a semiconductor die structure 2 with a first die side 2a and a second die side 2b opposite to the first die side 2a. A second component is formed as a lead frame 1 made from a metal material has a first frame side 1a and a second frame side 1b opposite to the first frame side 1a and has also at least two leaded terminals 1z₁. The semiconductor die structure 2 is mounted with its second die side 2b on the first frame side 1a of the lead frame 1.

As the third component, a three-dimensionally structured connecting element 3, is mounted on the first die side 2a of the semiconductor die structure 2 and is manufactured in accordance with the method steps of the disclosure. The three-dimensionally structured connecting element 3₁ bridges the gap or distance between the semiconductor die structure 2 and the leaded terminal 1z, and forms an electrical and mechanical connection.

In particular, it is provided in a layer-by-layer fashion by means of the forming sequence of the sub steps of i3-1) providing a layer 30 of a metal powder such that the metal powder is in contact with the first die side 2a of the semiconductor die structure 2 and the leaded terminals 1z, of the lead frame 1. Each layer deposition in according with sub-step i3-1) is followed by the sub-step i3-2) of selectively melting with laser light radiation L, the layer 30 of the metal powder to form a metal layer 30.

It should be note, that the step of providing a layer of metal powder may constitute depositing the powder particles, whereas the step of selectively melting may also encompass solidifying or sintering the metal powder.

Accordingly, the three-dimensionally structured connecting element 3₁ can be regarded as a stack of multiple metal layers 30. The forming sequence of the sub steps i3-1) and i3-2) allow a three-dimensional connecting element 3₁ to be structured, here in the shape of a curved bridging element, having a layered first element portion 3₁-a formed on the semiconductor die structure 2 and a second element portion 3₁-b formed on the leaded terminal 1z₁ and (the first die side 2a of) the semiconductor die structure 2.

The specific three-dimensional shape of the connecting element 3₁ can be established in the layer-by-layer forming steps as outlined in the sub-steps i3-1) and i3-2) of the method according to the disclosure. The local thickness and/or the local material density (kg/m³) of each metal layer formed during such forming sequence of the sub-steps i3-1) and i3-2) can be effectively controlled by adjusting one or more manufacturing parameters chosen from the group of: a metal powder distribution; a supply velocity of metal powder to be deposited; a metal powder depositing angle relative to a plane formed by the lead frame; a laser light power; a laser light frequency; a laser light wavelength; an ambient process temperature; a metal powder depositing duration time of step i3-1); a metal powder melting duration time of step i3-2).

Particular parameter characteristics can be:
- metal powder chosen from the list of metals disclosed below;
- supply velocities;
- a metal powder depositing angle;
- a power distribution of the laser light used;
- laser light frequency;
- laser light wavelength;
- ambient process temperature;
- depositing duration time and melting duration time.

There are several metals that can be 3D printed using metal powder, including: stainless steel, titanium, aluminum, cobalt-chrome, inconel, copper, nickel alloys, etc. The metal powders used for creating the metal connecting elements 3 are typically created through atomization or gas atomization, and are available in a range of particle sizes and shapes to accommodate the desired circumstances for creating the metal connecting elements 3 during the subs-steps i3-1) and i3-2).

For example, with the subs-steps i3-1) and i3-2) metal connecting elements 3 can be manufactured having a porous, metal density of e.g. 60%-90%, in particular 75%-85%, more in particular 80% resulting in a more flexible interconnection which has a longer life span and which is less fragile.

In particular, the density of the metal connecting elements 3 can be controlled flexibly at different location and/or in different portions of the elements 3 with the subs-steps i3-1) and i3-2) by adjusting the printing parameter characteristics outlined above. Herewith metal connecting elements 3 can be formed with an increased electrical conductivity (high density of metal powder) or if desired reduced stress characteristics (lower density of metal powder).

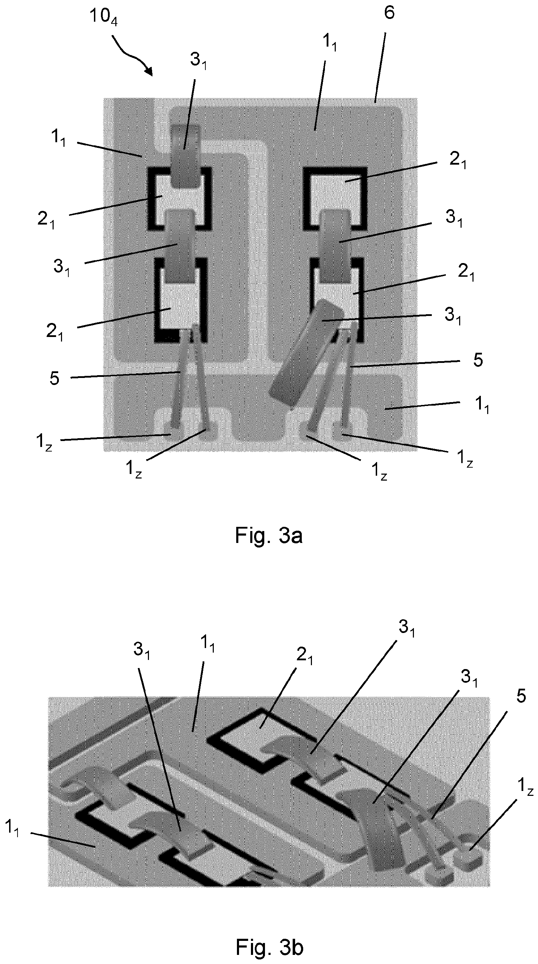

Figure 3a-3b show a top view and a detailed view of a power module 10₄ according to the disclosure. The power module 10₄ is formed of several lead frame parts 1₁ which are electrically separated from each other mounted to a substrate 6. Multiple semiconductor die structures 3₁ are mounted to the several lead frame parts 1, and are also electrically attached with each other by means of connection elements 3₁. These connection elements 3, are manufactured in a similar fashion as those elements 3₁ of the example of Figure 2a-2b.

Optionally, wire bonds 5 are provided between the semiconductor die structures 2, and other terminals 1z₂ of the lead frame 1₁.

The whole package of the substrate 6, the semiconductor die structures 2₁, the connection elements 3₁, the bond wires 5, the lead frame parts 1₁, and the plurality of terminals 1z₂ are encapsulated by a molding resin 4 (not shown), with only a portion of the terminals 1z₂ exposed.

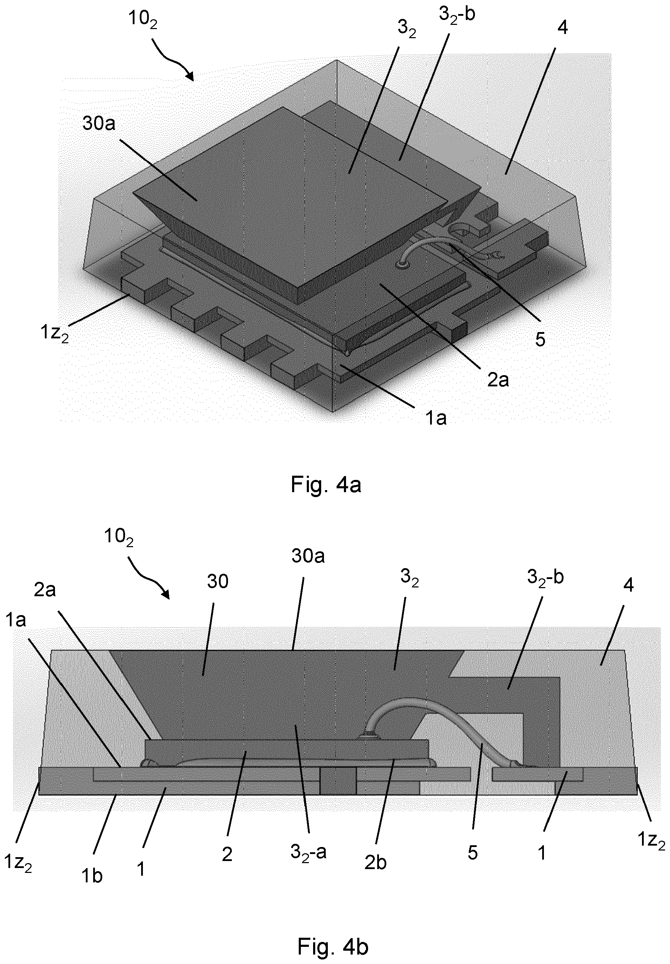

In another example, depicted in Figures 4a and 4b, the semiconductor package assembly 10₂ is a singulated leadless semiconductor package assembly. Similar as in the example of Figures 2 and 3, a semiconductor die structure 2 has a first die side 2a and a second die side 2b opposite to the first die side 2a. A lead frame 1 made from a metal material has a first frame side 1a and a second frame side 1b opposite to the first frame side 1a and has also at least two leadless terminals 1z₂. The semiconductor die structure 2 is mounted with its second die side 2b on the first frame side 1a of the lead frame 1.

The three-dimensionally structured connecting element 3₂ is being provided on the first die side 2a of the semiconductor die structure 2 in according with the method steps of the disclosure. In particular, the three-dimensionally structured connecting element 3₂ is provided in a layer-by-layer fashion by means of the forming sequence of the sub steps of i3-1) providing a layer 30 of a metal powder such that the metal powder is in contact with the at least one semiconductor die structure 2 and one of the at least two leadless terminals 1z₂ of the lead frame 1, followed by the sub-step i3-2) of selectively melting with laser light radiation, the layer 30 of the metal powder to form a metal layer 30.

Accordingly, the three-dimensionally structured connecting element 3₂ can be regarded as a stack of multiple metal layers 30. The forming sequence of the sub steps i3-1) and i3-2) allow a three-dimensional connecting element 3₂ to be structured, formed of a layered first element portion 3₂-a (the main portion) formed on the semiconductor die structure 2 (and functioning as a heat sink) and a second element portion 3₂-b functioning as an electrical interconnect between the leadless terminal 1z₂ and (the first die side 2a of) the semiconductor die structure 2.

Optionally, wire bonds 5 are provided between the semiconductor die structure 2 and another leadless terminal 1z₂.

The whole construction of the semiconductor die structure 2, the connection element 3₂, the bond wires 5 and the plurality of terminals 1z₂ are encapsulated by a molding resin 4, with only a portion of the leadless terminals 1z₂ exposed.

The above design flexibility of the connecting elements being formed in a layer-by-layer fashion allows metal layers to be formed with a surface dimension 30a (see Figure 4a), which surface dimension is larger than the surface dimension of the metal layer formed during the previous forming sequence. In other words, and as shown in Figure 4a-4b, by forming or depositing metal layers 30 on top of previous metal layers with a steadily increasing surface dimensions complex three-dimensionally shaped connecting elements 3₂ can be formed with a funneled shape. In this funneled shape, the connecting element 3₂ exhibits a large layer surface area on top and exposed at the outer surface of the package assembly 10₂ and a smaller layer surface area at the bottom at the interface with the first die side 2a of the semiconductor die structure 2. This three-dimensional shape allows the connecting element 3₂ to function as a heat sink.

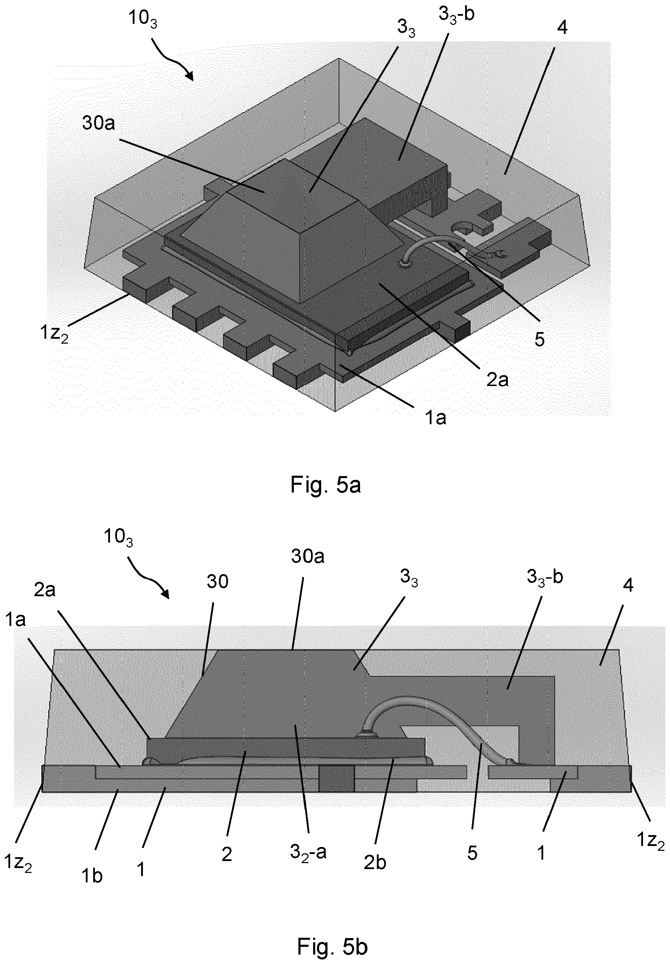

An example with a reverse funneled shape of a connecting element 3₃ is shown in the example of Figures 5a-5b.

In all examples of the semiconductor package assemblies 10₁-10₂-10₃-10₄ shown in this disclosure, each metal layer 30 being formed with the method sub-steps i3-1) and i3-2) may have a thickness of 30-40 µm, preferably 35 µm. Additionally, a local thickness and/or a local material density (kg/m³) of each metal layer formed during such forming sequence of the sub-steps i3-1) and i3-2) can be effectively controlled by adjusting one or more manufacturing parameters chosen from the group of: a metal powder distribution; a supply velocity of metal powder to be deposited; a metal powder depositing angle relative to a plane formed by the lead frame; a laser light power; a laser light frequency; a laser light wavelength; an ambient process temperature; a metal powder depositing duration time of step i3-1); a metal powder melting duration time of step i3-2) and in accordance with the parameter ranges mentioned in connection with the description of the example of Figures 2a-2b. Solder and/or adhesive promoters between the semiconductor die structure and resulting connecting elements and between the connecting elements and the lead frame can be omitted as the metal powder connection can be fused in between the material.

### LIST OF REFERENCE NUMERALS USED

- 10₁₋₂₋₃: semiconductor package (1^{st}, 2^{nd}, 3^{rd})
- 10₄: semiconductor package assembly / power module
- 1: lead frame
- 1a: first side of lead frame
- 1b: second side of lead frame
- 1z,: leaded terminal
- 1z₂: leadless terminal
- 2-2₁: semiconductor die
- 2a: first die side of semiconductor die
- 2b: second die side of semiconductor die
- 3₁-3₂-3₃: electrical/mechanical connection element (1^{st}, 2^{nd}, 3^{rd} example)
- 3₁-a /3₂-a: first element portion
- 3₁-b /3₂-b: second element portion
- 4: encapsulant
- 5: additional wire bond element
- 6: substrate
- 30: metal powder layer
- 30a: surface dimension

## Claims

1. A method for manufacturing a semiconductor package assembly, the method comprising the steps of
i) forming at least one semiconductor package by means of the sub-steps:
i1) providing a lead frame made from a metal material having a first frame side and a second frame side opposite to the first frame side as well as having at least two terminals;
i2) providing at least one semiconductor die structure having a first die side and a second die side opposite to the first side with its second die side on the first frame side of the lead frame;
i3) providing one or more connection elements between the at least one semiconductor die structures and the at least two terminals of the lead frame;
and
ii) encapsulating the at least one semiconductor die structure, the one or more connection elements and the plurality of terminals with a molding resin leaving at least a portion of at least two terminals exposed, thereby forming at least one encapsulated semiconductor package assembly;
wherein the step i3) comprises at least one forming sequence of the sub steps of:
i3-1) providing a layer of a metal powder such that the metal powder is in contact with the at least one semiconductor die structure and one of the at least two terminals of the lead frame;
i3-2) selectively melting with laser light radiation, the layer of the metal powder to form a metal layer.

2. The method for manufacturing a semiconductor package assembly according to claim 1, wherein the forming sequence of the steps i3-1) and i3-2) is performed multiple times alternately, thereby forming a three-dimensional stack of subsequent melted metal layers.

3. The method for manufacturing a semiconductor package assembly according to claim 1 or 2, further comprising controlling a local thickness and/or a local density of each metal layer formed during a forming sequence of the steps i3-1) and i3-2) by adjusting one or more manufacturing parameters chosen from the group of:
- a metal powder distribution;
- a supply velocity of metal powder to be deposited;
- a metal powder depositing angle relative to a plane formed by the lead frame;
- a laser light power;
- a laser light frequency;
- a laser light wavelength;
- an ambient process temperature;
- a metal powder depositing duration time of step i3-1);
- a metal powder melting duration time of step i3-2).

4. The method for manufacturing a semiconductor package assembly according to any one or more of the claims 1-3, wherein each metal layer formed in step i3-2) has a thickness of 30-40 µm, preferably 35 µm.

5. The method for manufacturing a semiconductor package assembly according to any one or more of the claims 1-4, wherein a surface dimension of a metal layer is larger than the surface dimension of the metal layer formed during the previous forming sequence.

6. The method for manufacturing a semiconductor package assembly according to any one or more of the claims 1-4, wherein a surface dimension of a metal layer is smaller than the surface dimension of the metal layer formed during the previous forming sequence.

7. The method for manufacturing a semiconductor package assembly according to any one or more of the claims 1-6, further comprising the step of iii) after a final forming sequence of steps i3-1) and i3-2) but before step ii), subjecting the exposed portion of the at least two terminals to a surface roughening treatment, for example using a chemical agent.

8. The method for manufacturing a semiconductor package assembly according to any one or more of the claims 1-7, further comprising the step of iv) after step ii) or step iii), plating the exposed portion of the at least two terminals with a metal plating material.

9. The method for manufacturing a semiconductor package assembly according to any one or more of the claims 1-8, further comprising the step v) after step iv), singulating the encapsulated semiconductor package from the lead frame, thereby forming a single semiconductor package assembly.

10. A semiconductor package assembly composed of a semiconductor die structure electrically and mechanically attached by means of one or more connection elements with at least two terminals and encapsulated by a molding resin such that a portion of the at least two terminals are exposed, wherein the one or more connection elements between the semiconductor die structure and the at least two terminals are formed according to the method steps of one or more of the method claims 1-9.

11. The semiconductor package assembly according to claim 10, wherein the semiconductor package assembly is a leadless semiconductor package assembly.

12. The semiconductor package assembly according to claim 10, wherein the semiconductor package assembly is a leaded semiconductor package assembly.
